# EUROPEAN PATENT APPLICATION

(11) **EP 0 972 561 A2**
(43) Date of publication of application: **19.01.2000**
(21) Application number: 99305547.4
(22) Date of filing: 13.07.1999
(51) Int. Cl.: B01J 3/00

(54) **Vacuum apparatus**

(30) Priority: 13.07.1998 JP 21354498
(71) Applicant: SEIKO SEIKI KABUSHIKI KAISHA, Narashino-shi Chiba (JP)
(72) Inventor: Okada, Takashi, c/o Seiko Seiki Kabushiki Kaisha, Narashino-shi, Chiba (JP); Nonaka, Manabu, c/o Seiko Seiki Kabushiki Kaisha, Narashino-shi, Chiba (JP); Kabasawa, Takashi, Seiko Seiki Kabushiki Kaisha, Narashino-shi, Chiba (JP)
(74) Representative: Sturt, Clifford Mark

(57) **Abstract**

A vacuum apparatus having a novel structure in which a non-uniformity of pressure distribution in the vicinity of a stage within a chamber can be eliminated is provided. The vacuum apparatus includes outlet ports 14 disposed at respective corners of the bottom surface of the chamber 10, and pressure gauges 16 are arranged in the vicinity of the outlet ports 14, respectively. The respective outlet ports 14 are communicated with a branch pipe 17 through conductance variable valves 19 (hereinafter referred to as simply "valve"), and a turbomolecular pump 15 is communicated with the end of the branch pipe 17. Signals showing pressure values outputted from the respective pressure gauges 16 are compared with target values of the respective pressure gauges 16 at control units to be outputted to a valve drive motor as the control signals that correspond to the differences between the target values. On the basis of the control signals, the valves 19 are opened/closed, to thereby control the amount of gas to be exhausted from the outlet port 14 is adjusted. As a result, the non-uniformity of the pressure distribution in the vicinity of the stage with the chamber 10 is eliminated.

## Description

The present invention relates to a vacuum apparatus that is used, for example, for dry etching, CVD, sputtering, ion injection, or the like, and more specifically, to a vacuum apparatus with which a non-uniformity of pressure distribution in a chamber can be eliminated.

In case of conducting dry etching, CVD, sputtering, ion injection, or the like in a semiconductor manufacturing equipment or a liquid crystal manufacturing equipment, etc., a vacuum apparatus is widely used in which vacuum pump such as a turbomolecular pump is used to perform the vacuum processing by discharging a process gas within a chamber.

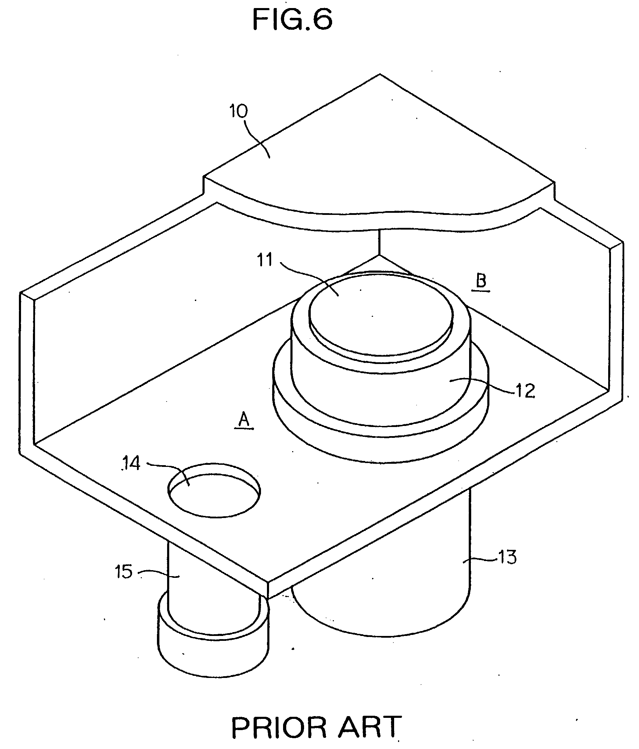

Fig. 6 shows an example of the vacuum apparatus that has been conventionally used.

As shown in Fig. 6, in the conventional vacuum apparatus, a stage 12 on which sample 11, etc. is placed is provided in a chamber (container) 10. Also, provided outside the chamber 10 is a drive mechanism 13 for rotating the stage 12 or for performing other functions from the downside of the stage 12. A turbomolecular pump 15 is mounted from the outside of the chamber 10 onto a portion of an outlet port 14 provided at the lower surface (or side surface) of the chamber so as to discharge the gas existing within the chamber 10.

However, an adjustment of the pressure within the chamber 10 is carried out by means of exhausting gas from an outlet port 14. Accordingly, the non-uniformity of the pressure distribution may occur in the chamber 10 dependent upon the distance, etc., from the outlet port 14. Further, if the sample 11 has a certain degree of area, the pressure in a side A that is closer to the turbomolecular pump 15 becomes lower, whereas the pressure in a side B that is far from the turbomolecular pump 15 becomes higher. Thus, there arises a problem in that the non-uniformity of the pressure distribution occurs in the vicinity of the sample 11, with the results that various conditions such as a manufacturing condition, a reaction condition, and a measurement condition, etc., for the sample 11 can not be equalized. In particular, in a process for manufacturing the semiconductors, since a wafer placed as the sample 11 on the stage 12 is gradually increased in diameter recently, the pressure difference around the wafer is liable to occur, which prevents the manufacturing of the uniform products.

As an attempt to equalize the pressure within the chamber 10, vacuum apparatuses having the following structures have been proposed.

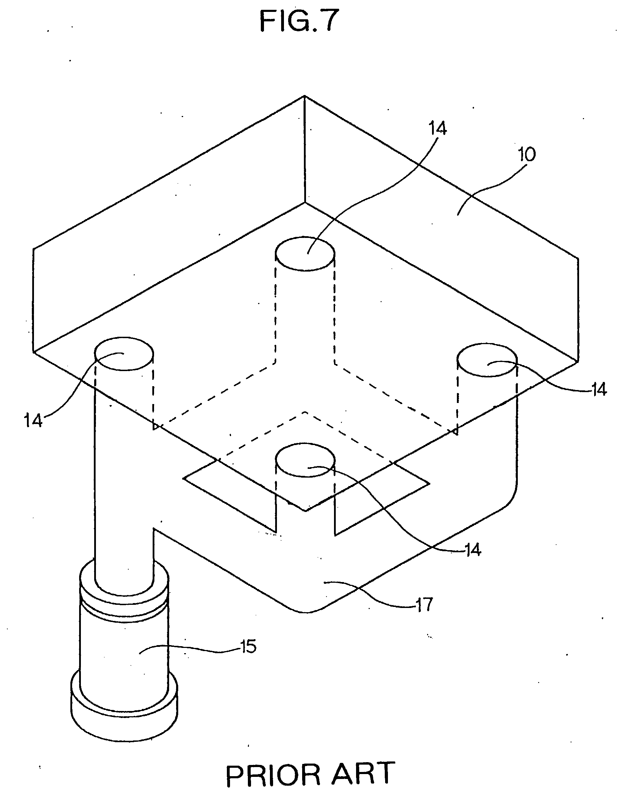

For example, as shown in Fig. 7, a plurality of outlet ports 14 are provided (four holes in the drawing) within the chamber 10 at equal intervals around the stage. The respective outlet ports 14 are connected through a branch pipe 17 to a single turbomolecular pump 15. Incidentally, although not shown in Fig. 7 for the illustration of the piping state, it is arranged such that the stage 12 is disposed at the central position with respect to the respective outlet ports 14, and the drive mechanism 13 for rotating the stage 12 is disposed at the central portion surrounded by the branch pipe 17.

Provision of the outlet ports 14 at equal intervals around the sample 11 in this manner allows the pressure around the sample 11 to be uniform.

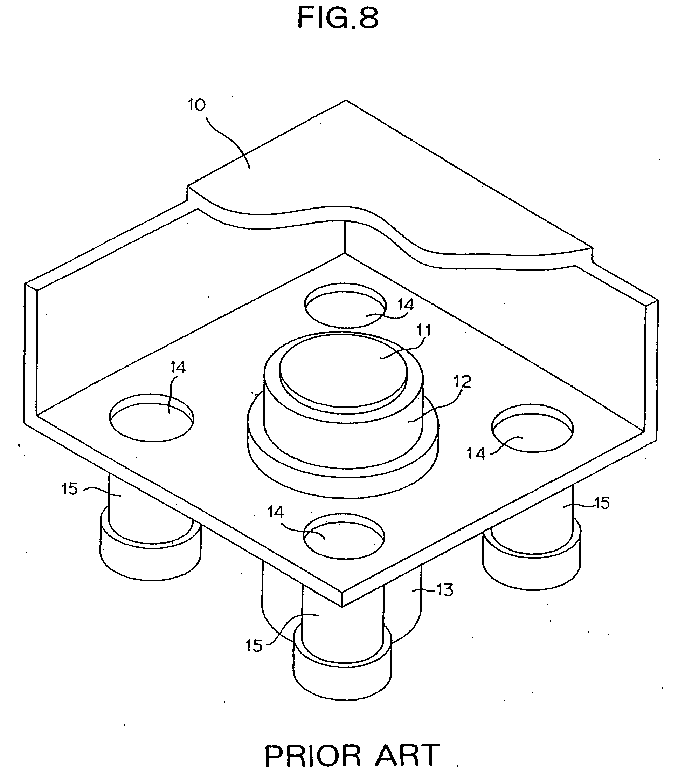

Further, as shown in Fig. 8, such a vacuum apparatus is also available in which the plurality of outlet ports 14 are provided (four holes in the drawing) within the chamber 10 at equal intervals around the stage, and the turbomolecular pumps 15 are provided to the respective outlet ports 14. Also, there exists a vacuum apparatus in which the branch pipes 17 are so configured as to symmetrize the turbomolecular pumps 15.

According to the vacuum apparatus thus constructed, since the exhaust operation is carried out by the turbomolecular pumps 15 through the plurality of outlet ports 14 disposed uniformly around the sample 11, non-uniformity of the pressure distribution can be eliminated.

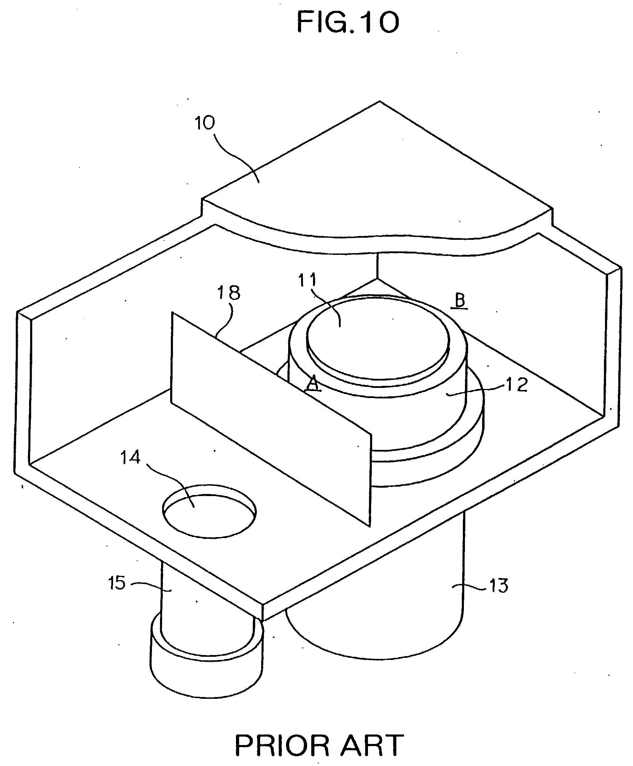

Further, such a vacuum apparatus, as shown in Fig. 10, is available in which a conductance adjustment plate 18 is disposed between the stage 12 and the outlet port 14 within the chamber 10.

In this vacuum apparatus, a single outlet port 14 is provided therefor. However, since the conductance adjustment plate 18 serves as a resistance plate against exhaust or discharge flow, it is possible to suppress the non-uniformity of the pressure distribution within the chamber 10.

In the vacuum apparatus shown in Fig. 7, however, since the drive mechanism is provided at the lower center of the chamber 10, the turbomolecular pump 15 must be disposed to keep out of the drive mechanism. Accordingly, the branch pipe 17 is also required to communicate with the turbomolecular pump 15 while avoiding the drive mechanism as an obstruction. This results in the fluctuation of conductance (exhaust resistance) in each outlet port 14 due to the piping, thereby causing the differences in air-sucking force from the outlet ports 14. Also, in the case of only four outlet ports 14 or so, there still occurs a non-uniform of the pressure between the vicinity of the respective outlet ports 14 and the intermediate position of the adjacent outlet ports 14 and 14. For that reason, although such non-uniformity of the pressure is eliminated in comparison with the vacuum apparatus shown in Fig. 6, there still remains a problem in that the pressure difference occurs. Further, if clogging occurs in the branch pipe 17 and the amount of gas exhausted from part of the outlet ports is varied, there is a risk that this state would not be corrected, resulting in causing the non-uniformity of the pressure distribution.

In the case of the vacuum apparatus shown in Fig. 8, since the turbomolecular pump 15 is independently installed for the respective outlet ports 14, the apparatus is free from the non-uniformity of conductance because of piping. However, as in the case shown in Fig. 7, there arises a problem in that in the case of only four outlet ports 14 or so, there still occurs the non-uniformity of the pressure between the vicinity of the respective outlet ports 14 and the intermediate position of the adjacent outlet ports 14 and 14.

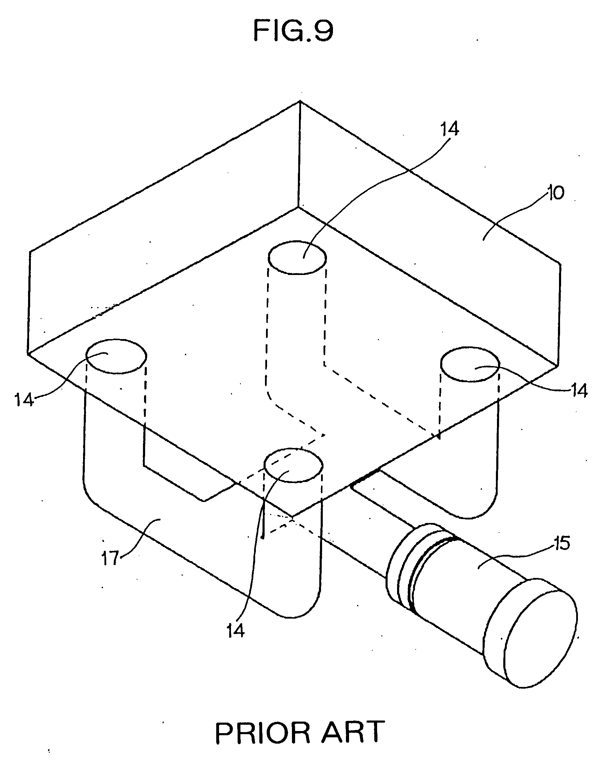

Even in the case shown in Fig. 9, if the number of exhaust ports is only four or so as well as the vacuum apparatus shown in Fig. 7 or Fig. 8, there still remains a problem in that the non-uniformity of the pressure occurs between the vicinity of the respective outlet ports 14 and the intermediate position of the adjacent outlet ports 14 and 14.

In the case of the vacuum apparatus shown in Fig. 10, provision of the conductance adjusting plate 18 increases the cost, and is insufficient to effectively eliminate the non-uniformity of the pressure distribution.

Accordingly, an object of the present invention is to provide a vacuum apparatus of a novel structure with which a pressure distribution in the vicinity of the stage within a chamber can be eliminated.

In order to attain the above-mentioned object of the present invention, there is provided a vacuum apparatus, comprising: a chamber; a plurality of pressure gauges for measuring pressure at a plurality of positions within the chamber; a plurality of outlet ports disposed at a plurality of positions within the chamber; at least one of pump for sucking and discharging gas within the chamber from the outlet ports; and means for adjusting an amount of gas to be exhausted from the respective outlet ports with the pump, on the basis of a pressure distribution measured by the pressure gauges.

According to the vacuum apparatus of the present invention, pressures at a plurality of positions within the chamber are measured as an index of a pressure distribution within the chamber with the plurality of pressure gauges, and an exhaust amount of gas within the chamber is calibrated on the basis of the measurement results. Accordingly, the amount of exhaust gas is calibrated irrespective of difference between the conductance of exhaust due to piping or of the difference between the places. As a result, the non-uniformity of the pressure distribution in the vicinity of a stage within the chamber can be effectively and appropriately eliminated.

In the above-mentioned vacuum apparatus, it may have such a structure that at least one of the outlet port is disposed in correspondent with the respective measurement positions of the pressure gauges, and the means for adjusting the amount of exhaust gas performs the control of the amount of exhaust gas independently for at least one of the outlet port in correspondent with each pressure gauge.

Further, in the above-mentioned vacuum apparatus, it may have such a structure that the means for adjusting the amount of exhaust gas includes: a valve disposed between the outlet port and the pump, for adjusting a flow rate of the gas exhausted from the outlet port to the pump; and a valve control unit for controlling the valve on the basis of the pressure distribution.

Still further, in the above-mentioned vacuum apparatus, it may have such a structure that the at least one of pump is plural, and the means for adjusting the amount of exhaust gas includes a pump control unit for controlling the r.p.m. of the plurality of pumps, respectively.

Embodiments of the present invention will now be described by way of further example only and with reference to the accompanying drawings, in which:
Fig. 1 is a schematic perspective view showing a vacuum apparatus according to an embodiment of the present invention;
Fig. 2 is a block diagram showing a control unit in the vacuum apparatus according to the embodiment of the present invention;
Fig. 3 is a schematic perspective view showing a vacuum apparatus according to another embodiment of the present invention;
Fig. 4 is a schematic perspective view showing a vacuum apparatus according to still another embodiment of the present invention;
Fig. 5 is a schematic perspective view showing a vacuum apparatus according to yet another embodiment of the present invention;
Fig. 6 is a schematic perspective view showing an example of the conventional vacuum apparatus;
Fig. 7 is a schematic perspective view showing another example of the conventional vacuum apparatus;
Fig. 8 is a schematic perspective view showing still another example of the conventional vacuum apparatus;
Fig. 9 is a schematic perspective view showing yet another example of the conventional vacuum apparatus; and
Fig. 10 is a schematic perspective view showing further another example of the conventional vacuum apparatus.

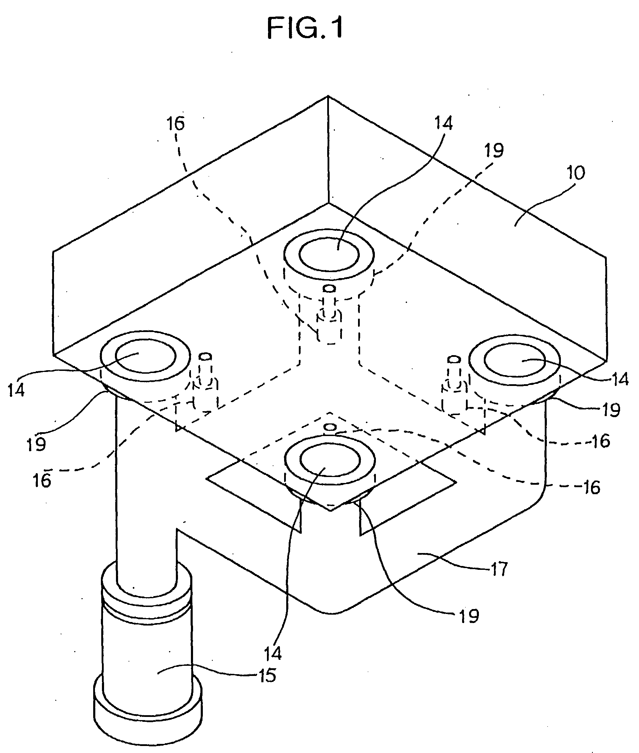

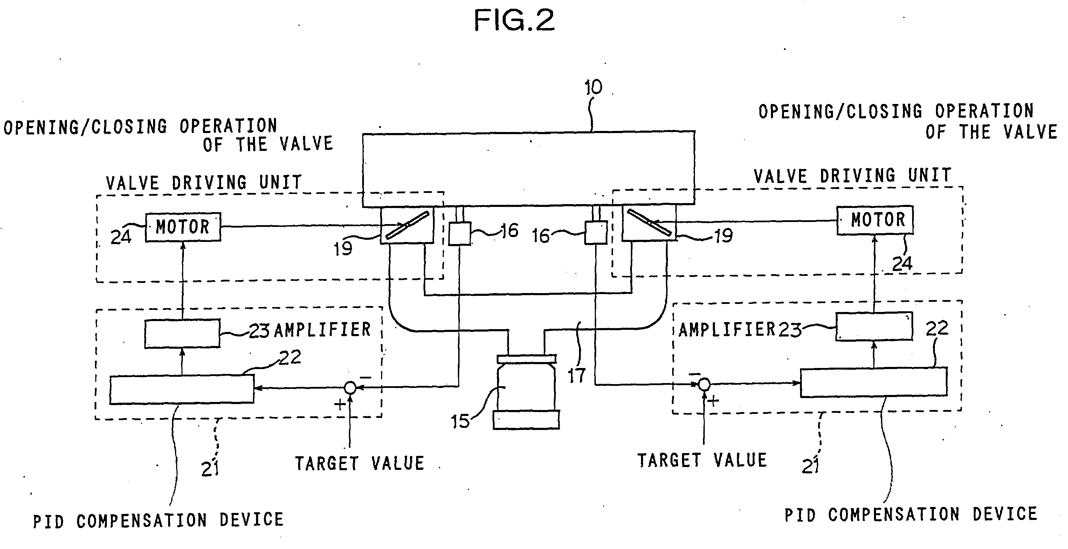

Hereinafter, preferred embodiments of the present invention will described in detail with reference to Figs. 1 and 2.

It should be noted that the identical components that have identical functions have been identified with identical reference numerals throughout the specification of the present invention for the sake of clarity and understanding of the invention.

Fig. 1 is a schematic perspective view showing the structure of a vacuum apparatus according to an embodiment of the present invention.

As shown in Fig. 1, in the vacuum apparatus of the present embodiment, a stage 12 (not shown) on which a sample 11 or the like (note shown) is placed is provided at the center of a bottom surface of a chamber 10 having a rectangular shape. A drive mechanism (not shown) for rotating the stage 12 or for performing other functions from the downside of the stage 12 is disposed outside the chamber 10.

These structures are the same as that of the above-mentioned conventional vacuum apparatus.

Four outlet ports 14 each are formed in each corner of the bottom surface of the chamber 10, and are arranged with an equal interval from the stage 12. The same number of pressure gauges 16 (pressure sensors) as the outlet port 14 (four in the present embodiment) are provided to the respective outlet ports on the stage 12 side so as to measure the pressure in the vicinity of the sample 11. As described above, in the present embodiment, the outlet ports 14 and pressure gauges 16 are disposed in a circumferential direction at equal intervals in contrast with the sample, thereby being likely to produce a uniform pressure distribution in the vicinity of the sample, and being facilitated in the control therefor.

The outlet ports 14 each are communicated with a branch pipe 17, respectively, via conductance variable valves 19 (hereinafter referred to as simply "valve"). A turbomolecular pump 15 is communicated with the end of the branch pipe 17 so that gas such as a process gas within the chamber 10 is sucked and exhausted from the outlet ports 14 to the branch pipe 17. The valves 19 are designed to be opened/closed with a valve driving motor so that the flow rate of the gas that is sucked and exhausted from the outlet ports 14 may be adjusted. The drive mechanism (not shown) of the stage 12 is disposed at a center portion surrounded by the branch pipe 17.

It is configured such that signals from the pressure gauges are outputted to a control unit to thereby control the drive of the valve driving motor by the control unit on the basis of the signals.

Fig. 2 is a block diagram showing the control unit in the vacuum apparatus according to the embodiment of the present invention.

It is to be noted that, in Fig. 2, although an illustration is made of two pairs of the pressure gauges 16 and valves 19, four pairs of the pressure gauges 16 and valves 19 are provided in an actual embodiment mode, and the similar controlling operation is performed thereto, respectively.

As shown in Fig. 2, it is configured that signals showing measured pressure values are outputted to the control unit 21 from the respective pressure gauges. In the control unit 21, respective measured values are compared with target values that are set with respect to the respective pressure gauges, and the difference therebetween are outputted to PID compensation devices 22. The control signals having values that correspond to the differences between target values are outputted from the PID compensation devices 22, and after amplified at an amplifier 23, the control signals are outputted to valve driving motors 24.

Then, the valve driving motors 24 are operated based on the input signal to conduct an opening/closing operation of the valves 19. With this arrangement, in the case where the pressure in the vicinity of one of the pressure gauges is high, the associated valve 19 is enlarged in the opening, allowing the amount of gas exhausted from the outlet port 14 to be increased. As a result, the pressure in the vicinity of the outlet port 14 is lowered.

As described above, in the present embodiment, an actual pressure distribution within the chamber 10 is detected by measurements of the pressures at a plurality of positions within the chamber 10. Then, the amount of gas to be exhausted from the outlet port 14 is calibrated on the basis of the above pressure distribution. Accordingly, according to the present embodiment, the amount of gas to be exhausted is calibrated independently at a plurality of positions regardless of the difference between the conductance of exhaust due to piping or of the difference between the places. As a result, it is possible to correct effectively, appropriately the pressure distribution within the chamber 10, and to eliminate the non-uniformity of pressure distribution in the vicinity of the sample 11.

According to the present embodiment, the pressure gauges 16 are provided in the vicinity of the sample 11 for detecting the pressure in the vicinity of the sample 11, and the amount of exhaust gas is independently controlled with the valves 19 provided to the respective outlet ports 14. As a result, if clogging occurs within the branch pipe 17, each valve provided to each outlet port 14 is released in accordance with the clogging state, thereby being capable of obtaining the uniform pressure distribution in the vicinity of the sample 11 without receiving the influence of clogging.

According to the present embodiment, the outlet ports 14 are arranged at equal intervals in the periphery of the stage 12. As a result, it is possible to set the pressure in the vicinity of the sample 11 to be uniform.

According to the present embodiment, the amount of gas exhausted from the outlet ports 14 is controlled so that the pressure distribution the chamber 10 is eliminated. As a result, it is possible to simultaneously control the pressure itself within the chamber 10.

According to the present embodiment, the amount of gas exhausted from the outlet ports 14 are varied on the basis of the target values that have been set by the control unit 21. As a result, it is possible to produce the pressure distribution in which the pressure in the vicinity of the stage has various magnitudes and is uniform, or the other various desired pressure distributions, by changing the target values to be set by the control units 21.

It should be noted that the vacuum apparatus according to the present invention is not limited to the one described in the above-mentioned embodiment, and various modifications may appropriately be employed.

For example, in the above-mentioned embodiment, the valves 19 are disposed as means for adjusting the amount of exhaust gas between the outlet ports 14 and the pump 15, for adjusting the flow rate of the gas exhausted from the outlet ports 14 to the pump 15. Also, the control units 21 control the opening/closing operation of the valves 19 on the basis of the pressure distribution measured by and sent from the pressure gauges. However, the vacuum apparatus according to the present invention is not limited thereto, and may have a structure in which one of the plurality of pumps 15 is provided in correspondent with at least one of the outlet ports 14, and the amount of gas to be exhausted from the pumps 15 is controlled by the control units 21. The control of the amount of gas to be exhausted from the pumps 15 may be performed, for example, by changing the r.p.m., etc., of each pump 15, or by changing the piping to the pump 15 from one to the other one having a different r.p.m.

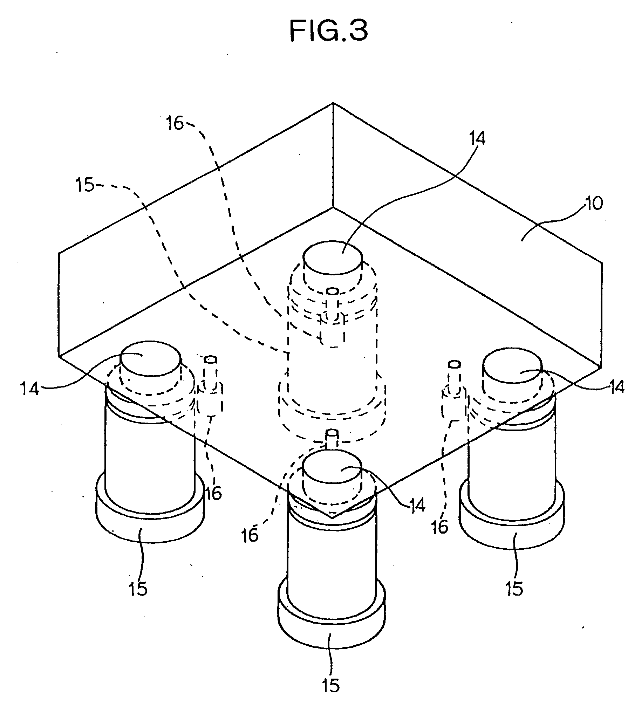

An example of embodiment thus constructed will be illustrated in Fig. 3. In the embodiment shown in Fig. 3, the pump 15 is individually communicated to each of the outlet ports 14. The output on the basis of the pressure measured by the pressure gauge 16 is outputted from the control unit 21 as the control signal in correspondent with the difference between the target value as well as the above-mentioned embodiment, and the r.p.m. of each pump 15 is controlled based on this control signal. By taking this arrangement, in the case where the pressure in the vicinity of the pressure gauge 16 is high, the r.p.m. of the pump 15 that sucks and exhausts the gas through the corresponding outlet ports 14, is increased, thereby being increased in the amount of gas exhausted from the outlet port 14. As a result, the pressure in the vicinity of the outlet port 14 is decreased. Also, in the case where the pressure in the vicinity of the pressure gauge 16 is low, the r.p.m. of the pump that sucks and discharges the gas through the corresponding outlet port 14 is decreased, thereby being decreased in the amount of gas exhausted from the outlet port 14. As a result, the pressure in the vicinity of the outlet port 14 is increased.

In the embodiment shown in Fig. 3, the same effect as the above-mentioned embodiment can be obtained. Further, since the plurality of pumps 15 are used in the present embodiment, the respective pumps 15 may be made small in size. Also, provision of a vertically thin-type turbomolecular pump having super small inertia allows a good r.p.m. response to be obtained to thereby rapidly eliminate the non-uniformity of the pressure distribution, with the result that it is capable of maintaining the stable and no pressure distribution state or an ideal pressure distribution state. Furthermore, the pumps may be provided in such a way that they are embedded to the frame.

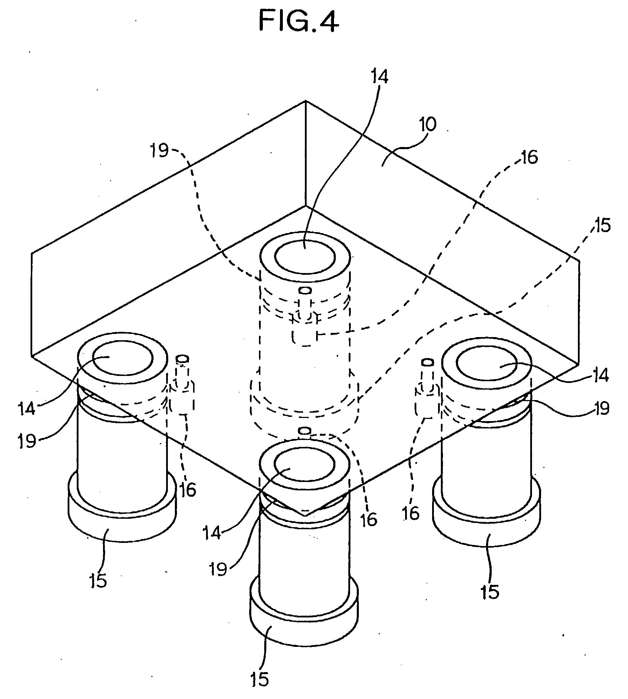

Further, as shown in Fig. 4, it may take a structure in which both of the valve 19 and pump 15 are provided to the respective outlet ports 14 so that the amount of exhaust gas is controlled by the valve 19 or the combination of the valve 19 and pump 15.

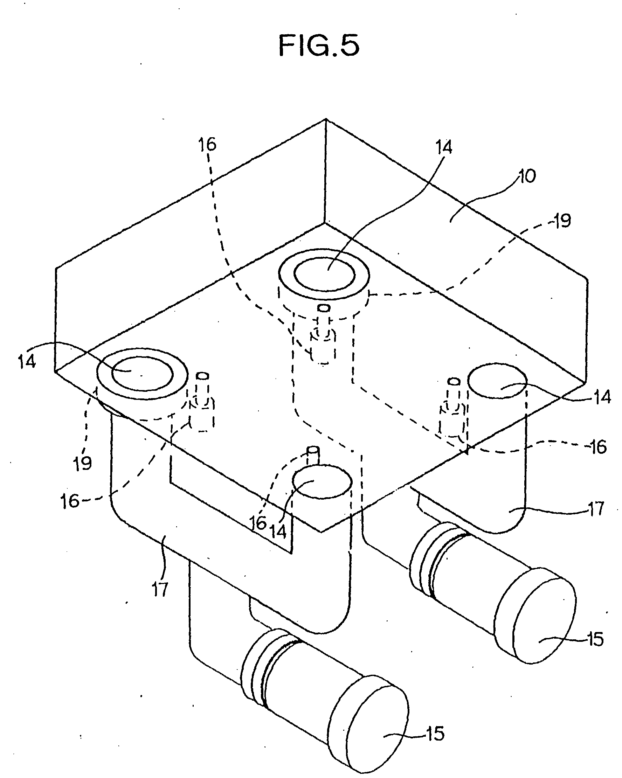

Furthermore, as shown in Fig. 5, it may adopt such a structure that either one of two outlet ports 14 constituting a pair of the outlet ports 14 is provided with a valve 19, and the same pump 15 is used for sucking and discharging the gas from the respective one pairs of the outlet ports 14. In this case, even if the opening/closing operation of the valves 19 is only controlled, or the opening/closing operation of the valves 19 and the r.p.m. of the pumps 15 are both controlled, the amount of gas exhausted from the respective outlet ports 14 can be independently controlled, thereby being capable of eliminating the non-uniformity of the pressure distribution in the vicinity of the stage, satisfactory.

It should be noted that even if the following structure is adopted in which without conducting the control of the amount of exhaust gas with respect to all the outlet ports 14, independently, for every plurality of outlet ports 14, one valve 19 is provided and/or one pump 15 is communicatingly provided so that the amount of exhaust gas is controlled up and down for every plurality of outlet ports 14, it is possible to eliminate the non-uniformity of the pressure distribution to some extent, or to obtain a desired pressure distribution state.

In the above-mentioned embodiments and respective modification examples shown in Figs. 3 to 5, although one pressure gauge 16 is disposed to each corner of the bottom surface, that is, total four pressure gauges 16 are provided for measuring the pressures at four corners, the present invention is not limited to the four places. However, since the measurement result of the pressure gauge is used as an index of the pressure distribution within the chamber 10, the number of the pressure gauges 16 are required to be plural. Further, the measuring positions are preferably the places where the pressure distribution may be satisfactory grasped judging from the shape of the chamber 10, the number and/or kinds of the members disposed within the chamber 10, positions of the outlet ports 14, and the like. Also, in order to grasp the pressure distribution exactly at the circumference of the sample placed on the stage 12, to thereby eliminate the non-uniformity of the pressure distribution, the measurement positions are preferably in the vicinity of the stage 12.

In the above-mentioned embodiments and the modification examples shown in Figs 3 to 5, although one outlet port 14 is provided in correspondent with each measurement position of the pressure gauge 16, the number of the outlet ports 14 may not always be identical with the number of measurement positions for measuring the pressure. However, in order to easily, appropriately adjust the amount of exhaust gas for each outlet port 14, at least one outlet port 14 is preferably arranged for each measurement position of the pressure gauge 16, to thereby measure the pressure in the vicinity of the exhaust port 14.

In the above-mentioned embodiments and the modification examples shown in Figs 3 to 5, the control units 21 set the respective target values of the pressure gauges 16 (pressure measuring position), and the opening/closing degree of the valve 19, the r.p.m. of the pump 15, or the like is controlled to adjust the amount of exhaust gas, based on the difference between the target value and the obtained pressure value. However, the target values may be set in accordance with the obtained pressure.

The target value is set as a mean value of every plurality of pressure gauges 16 (for example, every two pressure gauges). Accordingly, adjustment may be made of the amount of gas to be exhausted from each outlet port 14 among the respective plurality of exhaust ports 14, and may be made of the pressure for every measurement range of the plurality of pressure gauges 16.

Further, according to the purpose of use of the chamber 10, it may take such a configuration that the target value is not set in advance, and the highest value or the lowest value of the obtained pressure, or the mean value of all the measured pressures is used as it is as the target value.

As pumps that can be used for the above-mentioned embodiments and the modification examples shown in Figs. 3 to 5, there are exemplified a momentum transfer-type vacuum pump and a volume transfer-type vacuum pump.

As described above, according to the vacuum apparatus of the present invention, non-uniformity of the pressure distribution in the vicinity of the stage within the chamber can be satisfactory eliminated.

## Claims

1. A vacuum apparatus, comprising:
a chamber;
a plurality of pressure gauges for measuring pressure at a plurality of positions within said chamber;
a plurality of outlet ports disposed at a plurality of positions within said chamber;
at least one of pump for sucking and discharging gas within the chamber from said outlet ports; and
means for adjusting an amount of gas to be exhausted from said respective outlet ports with said pump, on the basis of a pressure distribution measured by said pressure gauges.

2. A vacuum apparatus as claimed in claim 1, wherein:
at least one of said outlet port is disposed in correspondent with the respective measurement positions of said pressure gauges; and
said means for adjusting the amount of exhaust gas performs the control of the amount of exhaust gas independently for at least one of said outlet port in correspondent with each pressure gauge.

3. A vacuum apparatus as claimed in claim 1, wherein said means for adjusting the amount of exhaust gas includes: a valve disposed between said outlet port and said pump, for adjusting a flow rate of the gas exhausted from said outlet port to said pump; and a valve control unit for controlling said valve on the basis of the pressure distribution.

4. A vacuum apparatus as claimed in claim 1, wherein said at least one of pump is plural, and said means for adjusting the amount of exhaust gas includes a pump control unit for controlling the r.p.m. of said plurality of pumps, respectively.
